# EUROPEAN PATENT APPLICATION

(11) **EP 0 584 827 A1**
(43) Date of publication of application: **02.03.1994**
(21) Application number: 93113692.3
(22) Date of filing: 26.08.1993
(51) Int. Cl.: G06G 7/25, G01R 19/22

(54) **Absolute value circuit**

(30) Priority: 27.08.1992 JP 252196/92
(71) Applicant: YOZAN INC., Tokyo 155 (JP); SHARP KABUSHIKI KAISHA, Osaka 545 (JP)
(72) Inventor: Shou, Guoliang, c/o YOZAN INC., Tokyo 155 (JP); Takatori, Sunao, c/o YOZAN INC., Tokyo 155 (JP); Yamamoto, Makoto, c/o YOZAN INC., Tokyo 155 (JP)
(74) Representative: Grünecker, Kinkeldey, Stockmair & Schwanhäusser Anwaltssozietät

(57) **Abstract**

It purposes to provide a proper absolute value circuit for an analog typed processing.

An absolute value circuit according to the present invention combines an analog type inverter circuit INVC and the maximum circuit MAXC, the inverter circuit INVC uses an operational amplifier comprised of CMOS, T1, T2 and T3 which are connected in a cascade with a gain 1, and the maximum circuit MAXC consists of a pair of nMOSs T4 and T5, the source follower outputs D4 and D5 of which are connected to a common output D₀.

## Description

### FIELD OF THE INVENTION

This invention relates to an analog typed absolute value circuit outputting an absolute value of an input voltage.

### BACKGROUND OF THE INVENTION

The digital computers have majority in computational systems, and addition, subtraction, multiplication, division and a lot of calculations are performed by digital computers. An analog type processing becomes also important, recently, for a neural network and other global information processings. In the digital processing, a calculation of absolute value can be realized by inverting a sign bit, however, an electrical value is evaluated and is to be inverted from negative to positive in the analog processing. There has not been a circuit preferable for absolute value calculation of analog type, as far as the inventors know.

### SUMMARY OF THE INVENTION

The present invention is invented so as to solve the above problems and has an object to provide an analog type circuit for calculating an absolute value.

According to the present invention, the absolute circuit is a combination of an inverter circuit and maximum circuit, the inverter circuit is an operational amplifier with a gain "1" which consists of CMOSs connected in a cascade, and the maximum circuit consists of a pair of nMOSs, the source follower outputs of which are connected to a common output.

### BRIEF DESCRIPTION OF THE DRAWINGS

Figure 1 is a diagram of a circuit showing an embodiment of the absolute value circuit according to the present invention.

Figure 2 is a partial circuit diagram showing another embodiment of the present invention.

### PREFERRED EMBODIMENT OF THE PRESENT INVENTION

Hereinafter an embodiment of an absolute value circuit according to this invention is described with referring to the attached drawings.

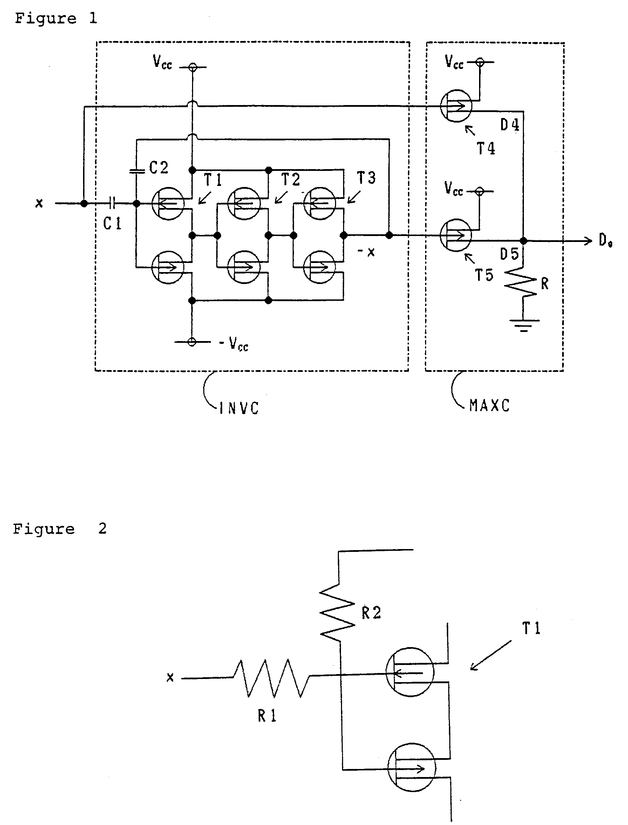

In Figure 1, an absolute value circuit has an inverter circuit INVC and a maximum value circuit MAXC, and an output of the inverter circuit is inputted to the maximum value circuit. An input voltage x is inputted to the circuit INV and MAXC, and a final output is outputted from MAXC.

An inverter circuit INVC consists of CMOST1, T2 and T3 connected in a cascade, the final output of the final stage CMOST3 is fed back to a gate of the CMOST1 in the first stage. An operational amplifier is constructed by the CMOSs from T1 to T3. An input voltage x is connected to a gate of T1 through a capacitance C1, and a capacitance C2 substantially equal to C1 is connected on a feedback line from T3 to T1. In the inverter circuit INVC, a positive power source Vcc is connected to each drain of pMOS, and a negative power source -Vcc is connected to a source of nMOS. In such a circuit, INVC becomes an inverting operational amplifier with gain 1, and a voltage of -x with inverted sign of an input voltage x is outputted. Here, a gain of INVC is given by a ratio of capacitances C1/C2, and an outputting characteristics of gain '1' is obtained by settling C1 equal to C2.

The gain of INVC is defined by the ratio of the impedance for input voltage and the impedance of feedback voltage. As shown in Figure 2, registers R1 and R2 can be used in place of C1 and C2. The maximum value circuit MAXC includes a pair of nMOSs T4 and T5, source follower outputs D4 and D5 of which are connected to a common output D_{O}. The input voltage x is inputted to a gate of nMOS T4 and -x from T3 is inputted to a gate of nMOST5.

Each of MOSs T4 and T5 outputs its input at the source as it is, as an independent characteristics. However, when the sources are connected with each other, the higher output outs the lower nMOS because its gate voltage becomes lower than the source voltage. As a result, the higher input voltage is to be generated on the common output D₀.

x and -x are inputted to MAXC. If x is larger than 0, then x is inputted. On the other hand, if x is smaller than 0, then -x is inputted. This is the result of an absolute value calculation.

It is easy to cooperate with another analog calculating circuit because it can execute an absolute calculation by using an analog input as it is.

The time for obtaining these outputs is equal to the response time of CMOS of 4 stages, and the calculation speed is much higher than that of digital circuit. It is clear that the size of the circuit is very small.

An absolute value circuit according to this invention combines an analog type inverter circuit and the maximum value circuit, the inventer circuit uses operational amplifier consisting of CMOSs connected in a cascade with gain "1", and the maximum value circuit consists of a pair of nMOSs, the source follower outputs thereof are connected to a common output. There is an advantages that a cooperation with an analog type calculating circuit is easy.

## Claims

1. An absolute value circuit comprising;
i) an inverter circuit to which an input voltage is input;
ii) the first nMOS having a gate to which an output of said inverter circuit is inputted;
iii) the second nMOS having a gate to which an output of said input voltage is inputted; and
iv) a common output to which source follower output of said nMOSs are connected.

2. An absolute value circuit as claimed in Claim 1 wherein;
i) said inverter circuit comprises a plurality of CMOSs connected in a cascade;
ii) each drain of pMOS in each said CMOS being connected to a power source of a positive voltage, each source of nMOS in each said CMOS being connected to source of a negative voltage with an absolute value equal to said positive voltage;
iii) an output of said CMOS in the final stage being fed back to a gate of CMOS in the first stage through an impedance, and
iv) said input voltage being inputted to said CMOS in the first stage through said impedance substantially equal to said impedance.

3. An absolute value circuit as claimed in Claim 2, wherein said impedance is a capacitance.

4. An absolute value circuit as claimed in Claim 2, wherein said impedance is a resistance.
